# EUROPÄISCHE PATENTSCHRIFT

(11) **EP 0 809 279 B1**
(45) Veröffentlichungstag und Bekanntmachung des Hinweises auf die Patenterteilung: **19.02.2003**
(21) Anmeldenummer: 97114782.2
(22) Anmeldetag: 19.08.1992
(51) Int. Cl.: H01L 21/20, H01L 21/336, H01L 21/331

(54) **Verfahren zur Herstellung eines MOS-Transistors**
Process for manufacturing an MOS-Transistor
Procédé pour la fabrication d'un transistor MOS

(30) Priorität: 23.09.1991 DE 4131619
(43) Veröffentlichungstag der Anmeldung: 26.11.1997
(62) Teilanmeldung aus: 92114161.0
(73) Patentinhaber: Infineon Technologies AG, 81669 München (DE)
(72) Erfinder: Klose, Helmut, Dr., Poughkeepsie, NY 12603 (US); Meul, Hans-Willi, Dr., 83052 Bruckmühl (DE); Meister, Thomas, Dr., 82024 Taufkirchen (DE); Stengl, Reinhard, Dr., 86391 Stadtbergen (DE)
(74) Vertreter: Zedlitz, Peter, Dipl.-Inf.

(56) Entgegenhaltungen:
- EP-A- 0 336 830
- EP-A- 0 430 279
- US-A- 4 324 038
- US-A- 4 529 455
- "RECESSED GATE MOS TRANSISTOR USING SELECTIVE EPITAXIAL DEPOSITION TECHNIQUES" RESEARCH DISCLOSURE, Nr. 308, 1.Dezember 1989, Seiten 937-939, XP000096109
- SATO F: "A "SELF-ALIGNED" SELECTIVE MBE TECHNOLOGY FOR HIGH-PERFORMANCE BIPOLAR TRANSISTORS" INTERNATIONAL ELECTRON DEVICES MEETING, SAN FRANCISCO, DEC. 9 - 12, 1990, Nr. -, 9.Dezember 1990, INSTITUTE OF ELECTRICAL AND ELECTRONICS ENGINEERS, Seiten 607-610, XP000279609

## Beschreibung

Seitlich begrenzte, einkristalline Gebiete, die durch selektive Epitaxie an der Oberfläche eines Substrats innerhalb begrenzender Strukturen hergestellt werden, finden in der Halbleitertechnologie zunehmend Anwendung. Aus EP 0 418 422 A1 ist zum Beispiel ein Bipolartransistor bekannt, dessen Kollektor durch selektive Epitaxie innerhalb eines von Oxidstrukturen begrenzten Bereichs auf der Oberfläche eines Substrats hergestellt wird. Bei der Verwendung eines solchen durch selektive Epitaxie hergestellten, einkristallinen Gebietes als aktiver Teil eines Transisstors sind hohe Anforderungen an die Kristallqualität zu stellen.

Bei der selektiven Epitaxie auf einem Substrat aus zum Beispiel Silizium innerhalb einer begrenzenden Struktur aus zum Beispiel Siliziumoxid werden die Abscheidebedingungen für das Silizium so eingestellt, daß das Silizium nur auf Siliziumoberflächen aufwächst. Da das Silizium entsprechend der Orientierung der Oberfläche des Substrats aufwächst, entsteht dabei innerhalb der begrenzenden Struktur ein einkristallines Gebiet. Es wird jedoch beobachtet, daß das einkristalline Gebiet in den der begrenzenden Struktur benachbarten Teilen Kristalldefekte aufweist.

Bei Verwendung eines durch selektive Epitaxie hergestellten einkristallinen Gebietes als aktiven Teil eines Transistors, zum Beispiel als Basis, ist es mitunter wünschenswert, das einkristalline Gebiet seitlich über eine entsprechend dotierte polykristalline Siliziumschicht anzuschließen. Es würde sich daher anbieten, das einkristalline Gebiet innerhalb einer begrenzenden Struktur aus Polysilizium aufzuwachsen. Dabei tritt jedoch das Problem auf, daß das Silizium nicht nur auf der einkristallinen Oberfläche des Substrats sondern auch auf den freiliegenden Oberflächen der polykristallinen Siliziumschicht aufwächst. Da die Oberfläche der polykristallinen Siliziumschicht keine einheitliche Kristallorientierung aufweist, kommt es in dem auf dem Polysilizium aufwachsenden Teil des einkristallinen Gebiets daher zu Korngrenzen in einem solchen Ausmaß, daß diese Teile nicht mehr als einkristallin bezeichnet werden können. Ein solches selektiv aufgewachsenes Siliziumgebiet kann die Anforderungen an die Kristallqualität für ein aktives Teil eines Transistors nicht mehr erfüllen.

Der Erfindung liegt daher das Problem zugrunde, ein Verfahren zur Herstellung eines MOS-Transistors anzugeben, der ein seitlich begrenztes, einkristallines Gebiet als aktives Teil umfaßt.

Dieses Problem wird erfindungsgemäß gelöst durch ein Verfahren nach Anspruch 1. Dabei wächst das einkristalline Gebiet auf der Oberfläche des Substrats auf, die seitlich durch die strukturierte erste Schicht begrenzt wird. Da die erste Schicht eine Unterätzung unter die zweite Schicht aufweist, liegen diejenigen Teile des einkristallinen Gebietes, in denen Kristalldefekte oder Korngrenzen auftreten, unterhalb der Kanten der zweiten Schicht. Innerhalb der strukturierten zweiten Schicht ist das so hergestellte einkristalline Gebiet im wesentlichen frei von Kristalldefekten und genügt den Anforderungen für den Einsatz als aktives Teil eines Transistors.

Es liegt im Rahmen der Erfindung, das einkristalline Gebiet durch Zugabe von Dotierstoff enthaltenden Verbindungen bei der selektiven Epitaxie in-situ zu dotieren. Das hat den Vorteil, daß das einkristalline Gebiet mit einem senkrecht zur Oberfläche des Substrats verlaufenden Dotierstoffprofil herstellbar ist. Es ist insbesondere möglich, das einkristalline Gebiet an der Oberfläche von einem Leitfähigkeitstyp zu dotieren und darunter eine dünne Schicht vom entgegengesetzten Leitfähigkeitstyp vorzusehen. Diese Möglichkeit ist zur Herstellung eines MOS-Transistors mit einem sogenannten Deltaförmig dotierten Kanalgebiet anwendbar.

Es wird insbesondere ein Substrat aus Silizium verwendet. Das einkristalline Gebiet darauf wird in der Regel aus dem gleichen Halbleitermaterial das heißt ebenfalls aus Silizium erzeugt. Es ist jedoch auch möglich, dem einkristallinen Gebieet ein weiteres Halbleitermaterial beizumischen, zum Beispiel Germanium, so daß das einkristalline Gebiet aus Si₁₋ₓGeₓ wobei x zwischen 0,2 und 0,4 liegt, besteht. Auf diese Weise ist das Verfahren zur Herstellung von Heterobauelementen geeignet.

Die erste Schicht wird aus SiO₂ und die zweite Schicht aus polykristallinem Silizium gebildet. Die Oberflächen und die Flanken der zweiten Schicht aus polykristallinem Silizium vor der Erzeugung der Unterätzungen werden mit einer dritten Schicht bedeckt, an deren Oberfläche bei der selektiven Epitaxie keine Keimbildung stattfindet und die den Ätzungen der zweiten Schicht und der ersten Schicht widersteht. Hierzu ist insbesondere Si₃N₄ geeignet. Die dritte Schicht aus Si₃N₄ kann nach der selektiven Epitaxie auf der zweiten Schicht aus polykristallinem Silizium verbleiben. Es ist jedoch vorteilhaft, sie zu entfernen, da dadurch Verspannungen in dem fertigen Bauelement vermieden werden.

Durch Dotierung der zweiten Schicht aus polykristallinem Silizium ist die zweite Schicht als Anschluß für das einkristalline Gebiet verwendbar. Auf diese Weise wird selbstjustiert zu dem einkristallinen Gebiet ein Anschluß gebildet.

Bei der Herstellung des MOS-Transistors wird die zweite Schicht aus polykristallinem Silizium gebildet. Das einkristalline Gebiet wirkt als Kanalgebiet. Die zweite Schicht wird so dotiert, daß an das Kanalgebiet angrenzende Teile der zweiten Schicht ein Source- und ein Drain-Gebiet bilden. An der Oberfläche des einkristallinen Gebiets wird ein Gatedielektrikum erzeugt. Auf dem Gatedielektrikum wird eine Gateelektrode gebildet, die von Source- und Drain-Gebiet isoliert ist. In diesem Herstellverfahren für einen MOS-Transistor sind Source- und Drain-Gebiete selbstjustiert zum Kanalgebiet angeordnet. Die Gateelektrode wiederum kann durch Verwendung einer Spacertechnik ebenfalls selbstjustiert zwischen Source- und Drain-Gebiet angeordnet werden. Durch geeignete Wahl der Schichtdicken der ersten Schicht und der zweiten Schicht sowie der Gateelektrode ist ein planarer MOS-Transistor herstellbar.

Durch Zugabe eines entsprechenden Dotierstoffes bei der Herstellung des einkristallinen Gebietes kann dabei das Kanalgebiet mit einem vertikalen Dotierstoffprofil versehen werden. Es ist insbesondere die Herstellung einer Delta-dotierten Schicht möglich. Eine Delta-dotierte Schicht wird als Ersatz für eine antipunch-Implantation bei MOS-Transistoren verwendet. Eine Delta-dotierte Schicht weist eine Dicke von etwa 20 nm auf. Sie ist vom entgegengesetzten Leitfähigkeitstyp wie Source- und Drain-Gebiet dotiert. Sie ist unterhalb des Bereichs des Kanalgebietes angeordnet, in dem sich im fertigen Transistor der Kanal ausbildet.

Im folgenden wird die Erfindung anhand eines Ausführungsbeispiels und der Figuren näher erläutert.

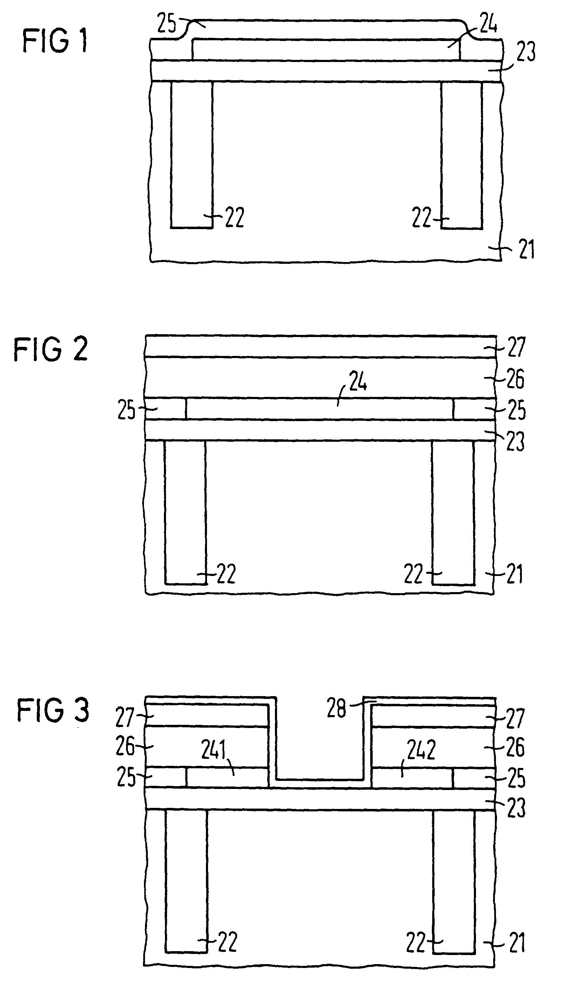

Figuren 1 bis 6 zeigen Herstellschritte eines Verfahrens zur Herstellung eines MOS-Transistors.

In einem Substrat 21 werden mit Isolationsmaterial gefüllte Gräben 22 (sogenannte Trenche) erzeugt (siehe Figur 1). Die Gräben 22 werden zum Beispiel nach der aus H. Goto, Springer Series in Electronics and Photonics, Bd. 27, Seiten 61 bis 77, beschriebenen Weise gebildet. Das Substrat 21 besteht zum Beispiel aus einkristallinem Silizium. An der Oberfläche des Substrats 21 wird eine erste Schicht 23 aus SiO₂ thermisch aufgewachsen. Auf der ersten Schicht 23 wird eine zweite Schicht 24 aus zum Beispiel p-dotiertem Polysilizium abgeschieden und strukturiert (siehe Figur 1). Nachfolgend wird ganzflächig und konform eine SiO₂-Schicht 25 zum Beispiel durch Zersetzung von TEOS abgeschieden. Die SiO₂-Schicht 25 wird mittels eines global planarisierenden Verfahrens wie zum Beispiel Rückschleifen oder Rückätzen über Epoxidharzen soweit entfernt, daß die Oberfläche der strukturierten zweiten Schicht 24 freigelegt wird (siehe Figur 2). An der Oberfläche der zweiten Schicht 24 und der SiO₂-Schicht 25 wird eine SiO₂-Schicht 26 und darauf eine Si₃N₄ -Schicht 27 erzeugt.

Nach einer photolithographischen Definition (nicht dargestellt) werden die Si₃N₄-Schicht 27 und die SiO₂-Schicht 26 durch eine anisotrope Ätzung strukturiert. Dabei wirkt die zweite Schicht 24 aus polykristallinem Silizium als Ätzstopp. In einer anisotropen Siliziumätzung wird auch die zweite Schicht 24 strukturiert. Dabei entstehen ein Source-Gebiet 241 und ein Drain-Gebiet 242. Anschließend wird ganzflächig eine Si₃N₄-Schicht 28 konform abgeschieden (siehe Figur 3).

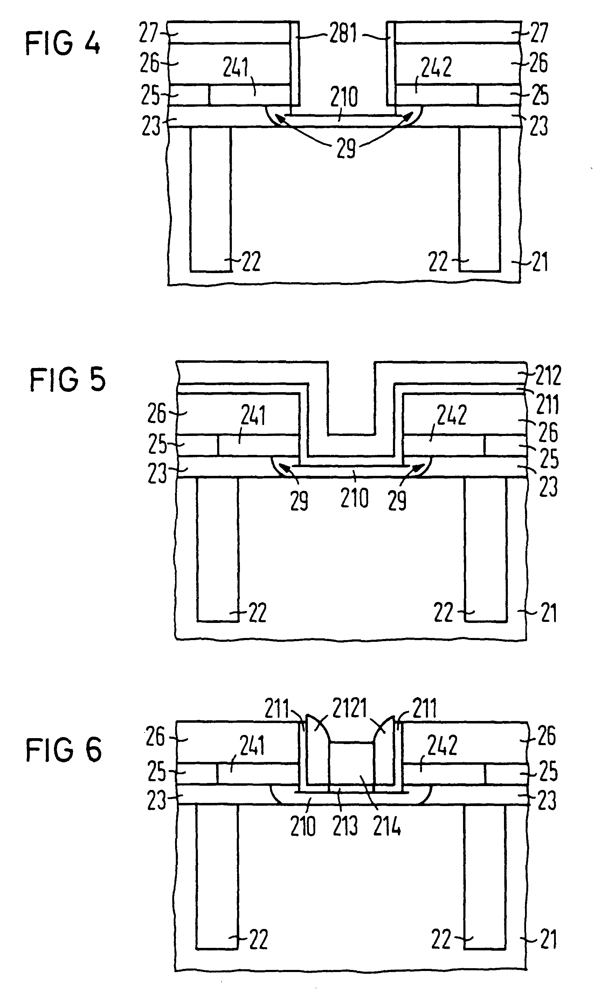

In einem anisotropen Ätzschritt, in dem die erste Schicht 23 als Ätzstopp dient, werden Flankenbedeckungen 281 an den senkrechten Flanken der Si₃N₄-Schicht 27, SiO₂-Schicht 26 und der zweiten Schicht 24 aus polykristallinem Silizium erzeugt (siehe Figur 4). In einem isotropen Ätzschritt, zum Beispiel naßchemisch wird die erste Schicht 23 bis zur Freilegung der Oberfläche des Substrats 21 entfernt. Die Ätzung erfolgt selektiv zum Substrat 21. Über die Dauer der Ätzung werden Unterätzungen 29 unter das Source-Gebiet 241 und das Drain-Gebiet 242 erzeugt. Mittels selektiver Epitaxie wird auf der freiliegenden Oberfläche des Substrats 21 ein Kanalgebiet 210 aufgewachsen. Das Kanalgebiet 210 wird zum Beispiel aus p-dotiertem Silizium gebildet. Es wächst sowohl an der Oberfläche des Substrats 21 als auch an den freiliegenden Oberflächen von Source- und Drain-Gebiet 241, 242 an. Facetten und Seitenwanddefekte liegen innerhalb der Unterätzungen 29. In diesem Gebiet stellt sich eine höhere Dotierung aufgrund von Ausdiffusion aus Source- und Drain-Gebiet 241 und 242 ein. Daher sind diese Kristalleffekte hier unschädlich für das Funktionieren des fertigen MOS-Transistors.

Nach Entfernung der Flankenbedeckungen 281 und der Si₃N₄-Schicht 27 zum Beispiel durch naßchemisches Ätzen selektiv zu SiO₂ und Silizium wird ganzflächig und konform eine SiO₂-Schicht 211 und darauf eine polykristalline Siliziumschicht 212 ebenfalls ganzflächig und konform abgeschieden (siehe Figur 5). In einem anisotropen Ätzschritt wird die polykristalline Siliziumschicht 212 rückgeätzt. Dabei werden aus der polykristallinen Siliziumschicht 212 Flankenbedeckungen 2121 gebildet (siehe Figur 6). Anschließend werden die freiliegenden Teile der SiO₂-Schicht 211 zum Beispiel naßchemisch selektiv zum Silizium entfernt. Dabei wird die Oberfläche des Kanalgebiets 210 freigelegt. Durch diese Herstellweise der Flankenbedeckungen 2121 wird im Vergleich zur Realisierung von Flankenbedeckungen aus Oxid eine Nachbehandlung zur Entfernung von Polymeren an der Oberfläche von Silizium überflüssig. Damit wird der Siliziumangriff während dieser Polymerentfernung auf dem einkristallinen Kanalgebiet 210 vermieden, was zu einer deutlichen Erhöhung der Prozeßstabilität führt.

Nachfolgend wird an der freiliegenden Oberfläche des Kanalgebiets 210 ein Gatedielektrikum 213 zum Beispiel durch thermische Oxidation erzeugt. Abschließend wird auf dem Gatedielektrikum 213 eine Gateelektrode 214 zum Beispiel aus dotiertem Polysilium gebildet. Ein planarer MOS-Transistor ergibt sich, wenn die Gateelektrode 214 den Zwischenraum zwischen den Flankenbedeckungen 2121 vollständig ausfüllt. Der MOS-Transistor wird schließlich durch Öffnen von Kontaktlöchern auf Source- und Drain-Gebiet 241, 242 und Metallisierung derselben in bekannter Weise (nicht dargestellt) fertiggestellt.

Der nach dem erfindungsgemäßen Herstellverfahren realisierte MOS-Transistor hat den Vorteil, selbstjustiert bezüglich Source/Drain und Gate zu sein. Da das Kanalgebiet abgeschieden wird, eröffnen sich die Möglichkeiten von Delta-dotierten Profilen oder Hetero-junction Profilen unter Verwendung von SiGe.

## Patentansprüche

1. Verfahren zur Herstellung eines MOS-Transistors mit folgenden Schritten:
a) auf einem Substrat (21) aus einkristallinem Silizium wird eine erste Schicht (23) aus SiO₂ erzeugt,
b) auf der ersten Schicht (23) wird eine zweite Schicht (24) aus polykristallinem Silizium erzeugt, zu der die erste Schicht (23) selektiv ätzbar ist,
c) die zweite Schicht (24) wird so strukturiert, daß ein Bereich für ein einkristallines Gebiet (210) freigelegt wird,
d) die Oberflächen und die Flanken der zweiten Schicht (24) werden mit einer dritten Schicht (28, 281) bedeckt, an deren Oberfläche bei der nachfolgenden selektiven Epitaxie keine Keimbildung stattfindet und die den Ätzungen der ersten Schicht (23) widersteht,
e) in einem zum Substrat (21) und zur zweiten Schicht (24) selektiven, isotropen Ätzschritt wird die Oberfläche des Substrats (21) innerhalb einer Unterätzung (29) der ersten Schicht (23) unter die zweite Schicht (24) freigelegt,
f) mittels selektiver Epitaxie wird auf der freiliegenden Oberfläche des Substrats (21) das einkristalline Gebiet (210) erzeugt,
g) die zweite Schicht (24) wird so dotiert, daß an das als Kanalgebiet wirkende einkristalline Gebiet (210) angrenzende Teile der zweiten Schicht (24) ein Source-Gebiet (241) und ein Drain-Gebiet (242) bilden,
h) an der Oberfläche des einkristallinen Gebiets (210) wird ein Gatedielektrikum (213) erzeugt,
i) auf dem Gatedielektrikum (213) wird eine Gateelektrode (214) gebildet, die von Source- und Drain-Gebiet (241, 242) isoliert ist.

2. Verfahren nach Anspruch 1,
bei dem das einkristalline Gebiet (210) durch Zugabe von Dotierstoff enthaltenden Verbindungen bei der selektiven Epitaxie in situ dotiert wird.

3. Verfahren nach einem der Ansprüche 1 oder 2,
bei dem das einkristalline Gebiet (210) aus Si₁₋ₓGeₓ mit x zwischen 0,2 und 0,4 gebildet wird.

4. Verfahren nach einem der Ansprüche 1 bis 3,
bei dem die dritte Schicht (28, 281) aus Si₃N₄ besteht.

5. Verfahren nach einem der Ansprüche 1 bis 4,
bei dem die dritte Schicht (28, 281) nach der selektiven Epitaxie vollständig entfernt wird.

6. Verfahren nach einem der Ansprüche 1 bis 5,
bei dem das einkristalline Gebiet (210) so mit einem Dotierstoffprofil versehen ist, daß es mindestens aus einem ersten und einem zweiten Teil besteht, wobei der erste Teil an Source- und Drain-Gebiet (241, 242) angrenzt und von demselben Leitfähigkeitstyp wie Source- und Drain-Gebiet (241, 242) dotiert ist und der zweite Teil unter dem ersten Teil angeordnet ist und vom entgegengesetzten Leitfähigkeitstyp wie Source- und Drain-Gebiet (241, 242) dotiert ist.

## Claims

1. Method for fabricating a mos transistor having the following steps:
a) a first layer (23) made of SiO₂ is produced on a substrate (21) made of monocrystalline silicon,
b) a second layer (24) made of polycrystalline silicon is produced on the first layer (23), and the first layer (23) can be etched selectively with respect to the said second layer,
c) the second layer (24) is patterned in such a way that a region for a monocrystalline region (210) is uncovered,
d) the surfaces and the sidewalls of the second layer (24) are covered with a third layer (28, 281), on whose surface no nucleation takes place during the subsequent selective epitaxy and which withstands the etchings of the first layer (23),
e) in an isotropic etching step which is selective with respect to the substrate (21) and with respect to the second layer (24), the surface of the substrate (21) is uncovered within an undercut (29) of the first layer (22) under the second layer (24),
f) by means of selective epitaxy, the monocrystalline region (210) is produced on the uncovered surface of the substrate (21),
g) the second layer (24) is doped in such a way that parts of the second layer (24) which adjoin the monocrystalline region (210) acting as channel region form a source region (241) and a drain region (242),
h) a gate dielectric (213) is produced on the surface of the monocrystalline region (210),
i) a gate electrode (214) is formed on the gate dielectric (213), the said gate electrode being insulated from the source and drain regions (241, 242).

2. Method according to Claim 1,
in which the monocrystalline region (210) is doped in situ by adding dopant-containing compounds during the selective epitaxy.

3. Method according to either of Claims 1 and 2,
in which the monocrystalline region (210) is formed from Si₁₋ₓGeₓ, where x is between 0.2 and 0.4.

4. Method according to one of Claims 1 to 3,
in which the third layer (28, 281) is composed of Si₃N₄.

5. Method according to one of Claims 1 to 4,
in which the third layer (28, 281) is completely removed after the selective epitaxy.

6. Method according to one of Claims 1 to 5,
in which the monocrystalline region (210) is provided with a dopant profile in such a way that it comprises at least a first and a second part, the first part adjoining the source and drain regions (241, 242) and being doped by the same conductivity type as the source and drain regions (241, 242) and the second part being arranged under the first part and being doped by the opposite conductivity type to the source and drain regions (241, 242).

## Revendications

1. Procédé de fabrication d'un transistor MOS comprenant les stades suivants :
a) on produit sur un substrat (21) en silicium monocristallin une première couche (23) en SiO₂,
b) on produit sur la première couche (23) une deuxième couche (24) en silicium polycristallin par rapport à laquelle la première couche (23) peut être attaquée chimiquement de manière sélective,
c) on structure la deuxième couche (24) de façon à mettre à nu une région pour un domaine (210) monocristallin,
d) on recouvre les surfaces et les flancs de la deuxième couche (24) d'une troisième couche (28, 281) à la surface de laquelle il ne se produit pas, lors de l'épitaxie sélective venant ensuite, de formation de germe et qui résiste aux attaques chimiques de la première couche (23),
e) on met à nu par un stade d'attaque chimique isotrope, sélectif vis à vis du substrat (21) et de la deuxième couche (24), la surface du substrat (21) dans une attaque (29) latérale de la première couche (23) sous la deuxième couche (24),
f) on produit au moyen d'une épitaxie sélective sur la surface mise à nu du substrat (21) le domaine (210) monocristallin,
g) on dope la deuxième couche (24) de façon à former, sur le domaine (210) monocristallin servant de domaine de canal des parties adjacentes de la deuxième couche (24), un domaine (241) de source et un domaine (242) de drain,
h) on produit sur la surface du domaine (210) monocristallin un diélectrique (213) de grille,
i) on forme sur le diélectrique (213) de grille une électrode (214) de grille qui est isolée du domaine (241) de source et du domaine (242) de drain.

2. Procédé suivant la revendication 1, dans lequel on dope in situ le domaine (210) monocristallin par addition de composés contenant de la substance de dopage lors de l'épitaxie sélective.

3. Procédé suivant l'une des revendications 1 ou 2, dans lequel on forme le domaine (210) monocristallin en Si₁₋ₓGEₓ, x étant compris entre 0,2 et 0,4.

4. Procédé suivant l'une des revendications 1 à 3, dans lequel la troisième couche (28, 281) est en Si₃N₄.

5. Procédé suivant l'une des revendications 1 à 4, dans lequel on élimine la troisième couche (28, 281) entièrement après l'épitaxie sélective.

6. Procédé suivant l'une des revendications 1 à 5, dans lequel on munit le domaine (210) monocristallin d'un profil de substance de dopage tel qu'il est constitué d'au moins une première partie et une deuxième partie, la première partie étant adjacente au domaine (241) de source et au domaine (242) de drain et étant dopée par le même type de conductivité que le domaine (241) de source et le domaine (242) de drain et la deuxième partie étant disposée sous la première partie et étant dopée par un type de conductivité opposé à celui du domaine (241) de source et à celui du domaine (242) de drain.
